# EUROPÄISCHE PATENTSCHRIFT

(11) **EP 0 660 411 B1**
(45) Veröffentlichungstag und Bekanntmachung des Hinweises auf die Patenterteilung: **11.03.1998**
(21) Anmeldenummer: 94119625.5
(22) Anmeldetag: 12.12.1994
(51) Int. Cl.: H01L 27/08, H01L 21/3205, H01L 29/92

(54) **Integrierte Halbleiterschaltung mit Kondensatoren genau definierter Kapazität**
Integrated semiconductor circuit with capacitors having exactly defined capacities
Circuit intégré semi-conducteur avec des condensateurs à capacité précisement définie

(30) Priorität: 22.12.1993 DE 4343983
(43) Veröffentlichungstag der Anmeldung: 28.06.1995
(73) Patentinhaber: SIEMENS AKTIENGESELLSCHAFT, 80333 München (DE)
(72) Erfinder: Hain, Manfred, Dipl.-Phys., D-85591 Vaterstetten (DE); Fischer, Elisabeth, Dipl.-Ing. (FH), D-83112 Frasdorf (DE)

(56) Entgegenhaltungen:
- EP-A- 0 296 658
- WO-A-81/00171
- PROCEEDINGS OF THE IEEE, Bd.67, Nr.1, Januar 1979 Seiten 61 - 75 R.W. BRODERSEN ET AL.
- IEEE TRANSACTIONS ON CIRCUITS AND SYSTEMS, Bd.36, Nr.6, Juni 1989 Seiten 912 - 916, XP38475 R. SINGH ET AL.

## Beschreibung

Die Erfindung betrifft eine integrierte Halbleiterschaltung mit einem ersten Gebiet, in welchem Kondensatoren angeordnet sind, wobei die Kondensatorplatten aus einer ersten und einer zweiten leitenden Schicht gebildet sind, und einem zweiten Gebiet, in welchem Schaltungselemente angeordnet sind.

Eine solche Halbleiterschaltung wird beispielsweise in der Schift WO 81/00171 (entspricht dem Oberbegriff des Anspruchs 1) beschrieben.

Bei vielen Typen von integrierten Schaltungen spielt das Problem eine große Rolle, einen oder mehrere Kondensatoren mit einer sehr genau definierten Kapazität herzustellen. Dabei kann der Absolutwert der Kapazität und/oder die relative Genauigkeit der Kapazitäten verschiedener Kondensatoren wesentlich sein.

Ein Beispiel dafür sind A/D-Wandler, die üblicherweise mit Hilfe von Kondensatornetzwerken realisiert werden. Die Kondensatoren müssen dazu beispielsweise bei 8Bit-Wandlern eine relative Genauigkeit von unter 200 ppm aufweisen. Dies ist notwendig, da für eine eindeutige Umwandlung von analogen in digitale Signale bzw. umgekehrt ein monotoner Zusammenhang zwischen analogem und digitalem Signal erforderlich ist, oder zumindest die Nicht-Monotonie kleiner als 1Bit (nämlich das least significant bit, LSB) sein muß. Das Matching-Verhalten der Schaltung wird unter anderem dadurch bestimmt, wie gut diese Forderung erfüllt ist ( s. IEEE Trans.on Circuits and Systems, Vol.25 No 7, July 78, S. 419).

Bspw. in CMOS-Prozessen können geeignete Kapazitäten in verschiedenen Ebenen realisiert werden, z. B. Polysilizium zu Substrat, Polysilizium 1 zu Metall 1, Polysilizium 1 zu Polysilizium 2 oder Metall 1 zu Metall 2. Bei den Polysilizium-Ebenen als Kondensatorplatten muß berücksichtigt werden, daß die Dotierungen relativ hoch (ca. 10²⁰/cm²) liegen müssen, um die notwendige Konstanz bei Spannungsänderung zu erreichen. Derartig hohe Dotierungen lassen sich nicht immer mit den Anforderungen des Gesamtprozesses an das Gate-Polysilizium vereinbaren, oder erfordern im Siliziumsubstrat eine zusätzliche Dotierung mit einer Maske. Bei der Verwendung von Polysilizium und Substrat für die Kapazität werden wegen der meist geringen Gate-Oxyd-Dicken heutiger CMOS-Generationen hohe spezifische Kapazitäten erreicht, was die Umladezeit negativ beeinflußt. Bei hinreichend geringen Strukturtoleranzen von Lithographie- und Ätzprozessen können jedoch ausreichend kleine Kondensatorflächen (zur Erhöhung der Geschwindigkeit) mit der notwendigen Genauigkeit hergestellt werden. Zumindest in Prozeßoptionen mit zwei Polysilizium-Ebenen kann es bei Berücksichtigung dieser Randbedingungen vorteilhaft sein, die Kapazitäten unter Verwendung einer oder beider Polysilizium-Ebenen herzustellen.

Wird nur eine Polysilizium-Ebene prozessiert, ist oft eine Metall 1/Metall 2-Kapazität geeigneter. Sie wird auch in 0,7 µm CMOS-Generationen mit Erfolg für 10Bit-A/D-Wandler mit Linearitäten von 0,5 LSB eingesetzt.

Insbesondere bei zukünftigen Generationen muß das Dielektrikum zwischen den leitenden Schichten, aus denen die Kondensatorplatten gebildet werden, langreichweitig planarisiert werden. Beispielsweise betragen die typischen Planarisierungslängen beim Intermetalldielektrikum bei Verwendung von Spin-on-Glas-Planarisierungstechniken 10 bis 100 µm. Dies führt über die typischen Dimensionen eines A/D-Wandler-Kondensatornetzwerks von einigen 100 µm zu unakzeptablen Dickenschwankungen im Kondensatordielektrikum. Bei 10Bit-A/D-Wandlern führt die Planarisierung mit SOG bereits zu Linearitätsfehlern von 2 bis 4 LSB und damit zu massiven Ausbeuteverlusten durch das Auftreten von sogenannten Missing Codes.

Die Erfindung hat daher zur Aufgabe, bei integrierten Halbleiterschaltungen die absolute oder relative Genauigkeit der Kapazität eines oder mehrerer Kondensatoren zu verbessern.

Diese Aufgabe wird durch eine integrierte Halbleiterschaltung mit den Merkmalen des Patentanspruchs 1 und durch ein Verfahren mit den Merkmalen des Patentanspruchs 8 gelöst.

Bei der Erfindung besteht die isolierende Schicht zwischen den beiden leitenden Schichten aus einer Planarisierungsschicht und einer Deckschicht im zweiten Gebiet, in dem nur Schaltungselemente angeordnet sind, bei denen die Genauigkeitsanforderung an die Kapazität geringer ist. Im ersten Gebiet, in dem ein oder mehrere Kondensatoren mit genau einzustellender Kapazität angeordnet sind, besteht die Isolierschicht zwischen den Kondensatorplatten nur aus der Deckschicht.

Zur Herstellung einer solchen Anordnung kommen insbesondere Verfahren in Frage, bei denen im ersten Gebiet die Planarisierungsschicht oberhalb der ersten leitenden Schicht wieder vollständig entfernt wird, eventuell bis auf einen von der Justiergenauigkeit abhängigen Randbereich des ersten Gebietes. Die Dicke des aus der Deckschicht gebildeten Kondensatordielektrikums ist also sehr gleichmäßig und kann genau eingestellt werden. Das Matching-Verhalten wird dadurch entscheidend verbessert, und bei Änderung der Design-Regeln (Änderung der Kondensatorfläche) kann die Kapazität sehr einfach angepaßt werden (durch Änderung der Deckschicht-Dicke).

Die vorgeschlagene Lösung ist auch bei anderen Planarisierungstechniken als SOG einsetzbar (beispielsweise Planarisierung mittels BPSG-Verfließen oder Lack-Planarisierung). Darüber hinaus wird ein eventueller Memory-Effekt durch Polarisation der Planarisierungsschicht, wie er beispielsweise bei SOG auftreten kann, vermieden.

Bei der Erfindung ist das Kondensatordielektrikum dünner als bei konventionellen Verfahren, dies ist aber für die Geschwindigkeit z.B. eines A/D-Wandlers kein Problem. Die Herstellung hochlinearer A/D-Wandler (Fehler < 1 LSB) bei gleichzeitig optimaler Planarisierung der Schaltung wird ermöglicht. Die vorgeschlagene Lösung ist auch bei A/D-Wandlern mit hoher Auflösung geeignet.

Die Erfindung wird im folgenden anhand eines Ausführungsbeispiels und den Figuren näher erläutert. Die Figuren zeigen:
- Figur 1: eine Aufsicht auf einen A/D-Wandler als Beispiel für eine integrierte Halbleiterschaltung;
- Figur 2: einen ausschnittsweisen Querschnitt durch die Halbleiterstruktur, an dem die wesentlichen Verfahrensschritte einer Ausführungsform der Erfindung erläutert werden;
- Figur 5: eine Messung der Dielektrikums-Dicke über ein Kondensatorfeld, wobei das Dielektrikum bei a) mit einem konventionellen Verfahren und bei b) mit dem erfinderischen Verfahren hergestellt wurde.

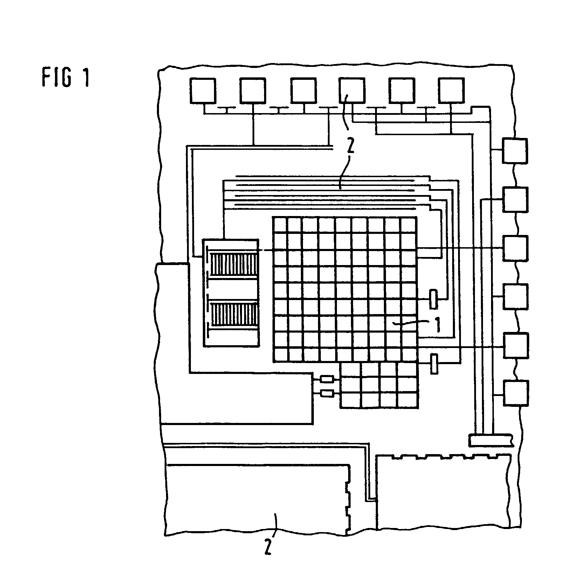

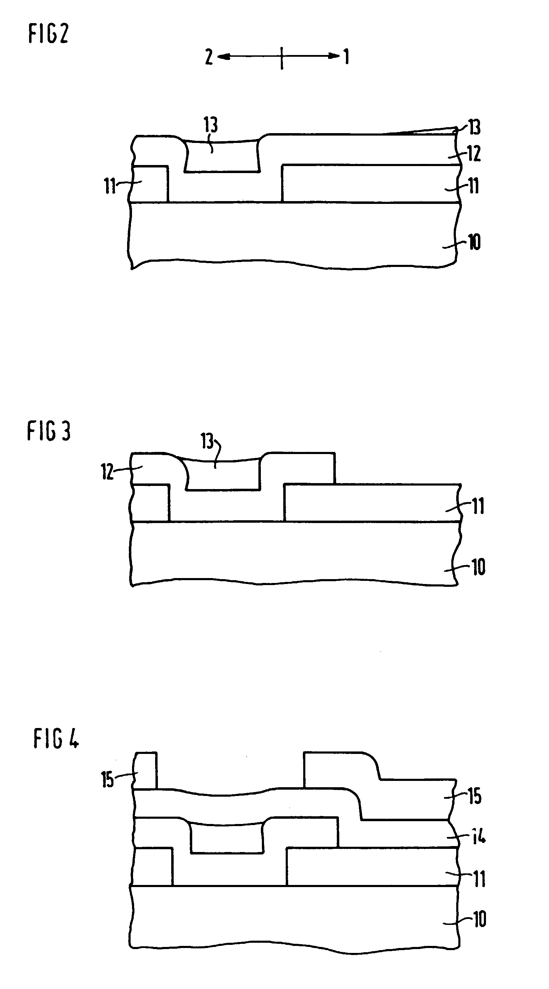

Figur 1: Bei der Aufsicht auf einen Ausschnitt eines A/D-Wandlers ist ein erstes Gebiet 1 zu erkennen, in dem Kondensatoren angeordnet sind, deren Kapazität aus den oben erläuterten Gründen sehr genau eingestellt werden muß. Außerhalb des ersten Gebietes befindet sich das zweite Gebiet 2, in welchem verschiedene Schaltungselemente, Anschlüsse und anderes angeordnet sind, die beispielsweise in CMOS-Technik realisiert sind.

Figur 2: Das erfinderische Verfahren wird an einem Prozeß erläutert, bei dem der Kondensator aus zwei Metallschichten gebildet wird. In der Figur ist der Grenzbereich von erstem Gebiet 1 und zweitem Gebiet 2 im Querschnitt durch ein Halbleitersubstrat 10 dargestellt. Als erste leitende Schicht 11 befindet sich eine strukturierte Metallschicht, beispielsweise eine Aluminium-Legierung, auf dem Substrat 10. Selbstverständlich können zwischen Substrat 10 und erster Metallschicht 11 weitere, nicht dargestellte Schichten angeordnet sein. Im ersten Gebiet dient die Metallschicht 11 als erste Kondensatorplatte, im zweiten Gebiet können beispielsweise Leitbahnen aus ihr gebildet sein. Die erste Metallschicht 11 ist mit einer Planarisierungsschicht 12, 13 abgedeckt. In diesem Fall wird die Planarisierungsschicht durch eine PECVD-Silizium-Oxyd-Schicht 12 und eine darüberliegende SOG-Schicht 13 gebildet, wobei nach Aufbringen des SOG ein konventioneller Rückätzschritt durchgeführt wurde. Die Schichtdicken können beispielsweise betragen: 700 nm Silizium-Oxyd, 600 nm SOG, SOG-Rückätzung: 770 nm. Dabei sind weite Variationen um diese beispielhaften Werte möglich. Insbesondere kann auch ein sehr viel dünneres Oxyd eingesetzt und/oder auf eine Rückätzung des SOG verzichtet werden. Die Planarisierung kann auch mit einer anderen Hilfsschicht als SOG erzielt werden, und es kann auch eine einfache Planarisierungsschicht (ohne Hilfsschicht), beispielsweise ein in-situ planarisiertes Oxyd, eingesetzt werden.

Figur 3: Nun wird, beispielsweise mit Hilfe einer Fototechnik, die Planarisierungsschicht im ersten Gebiet entfernt, bis die erste leitende Schicht 11 freiliegt. Dabei sind Justiertoleranzen zu berücksichtigen, d. h. die Kante der ersten Planarisierungsschicht 12, 13 ist im allgemeinen nicht genau deckungsgleich mit der Grenze zwischen dem ersten und zweiten Gebiet. Der Kantenlagefehler beträgt typischerweise wenige Zehntel µm, wobei in diesem Fall die Planarisierungsschicht 12, 13 noch in den Randbereich des ersten Gebiets 1 hineinragt. Die Kante der Planarisierungsschicht kann auch im Randbereich des zweiten Gebietes 2 liegen, wobei darauf zu achten ist, daß bei nachfolgenden Prozeßschritten keine Kantenbedeckungsprobleme an der Metall 1-Kante auftreten. Außerdem besteht die Gefahr von Kurzschlüssen in der Metall-2-Ebene, wenn nach der Metall-2-Ätzung Reste an der Stufe verbleiben. In jedem Fall ist fast überall im ersten Gebiet die Oberfläche der ersten leitenden Schicht 11 freigelegt. Im zweiten Gebiet bleibt die erreichte Planarisierung erhalten, da hier die Planarisierungsschicht 12, 13 nicht entfernt wird.

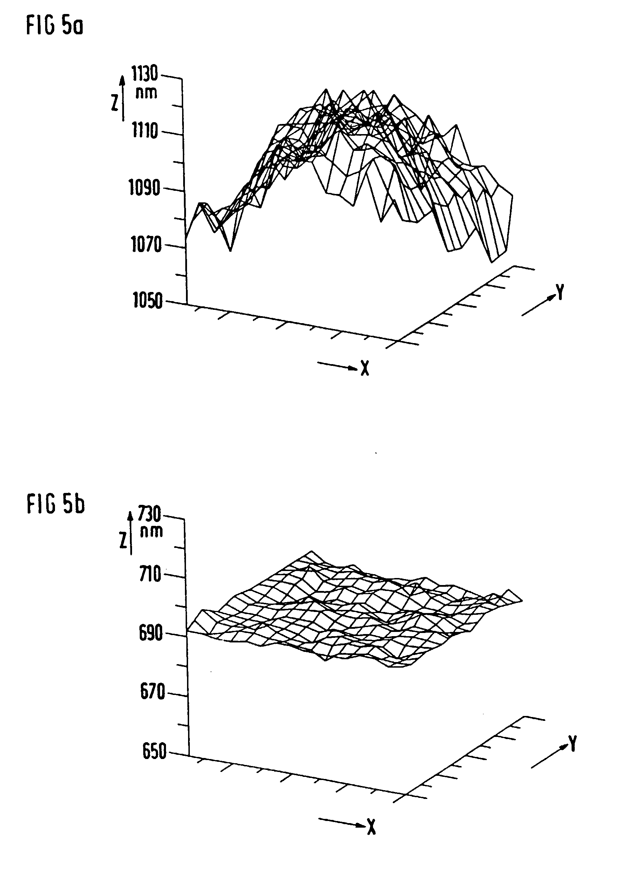

Figur 4: Es wird ganzflächig eine isolierende Deckschicht 14, hier ein PECVD-Silizium-Oxyd von etwa 700 nm Dicke abgeschieden, deren Schichtdicke sehr konstant und genau einstellbar ist. Diese Deckschicht 14 kann an geeigneten Stellen im zweiten Gebiet mit Kontaktlöchern (nicht dargestellt) zu unterliegenden leitenden Ebenen versehen werden. Es wird eine zweite leitende Schicht 15, beispielsweise eine Aluminiumlegierung von etwa 1000 nm Dicke mit einer evt. Barriereschicht, aufgebracht und strukturiert. Im ersten Gebiet wird durch den Überlapp der beiden leitenden Schichten 11, 15 die Kondensatorfläche bestimmt. Im ersten Gebiet besteht das Dielektrikum zwischen den leitenden Schichten nur aus der Deckschicht 14, wenn von dem durch den Kantenlagefehler erzeugten Randbereich abgesehen wird. Dieser Randbereich verändert die Kapazität nicht meßbar bzw. trägt nicht zur effektiven Kapazität bei. Im zweiten Gebiet wird die Isolierung zwischen den beiden leitenden Schichten 11, 15 durch die Planarisierungsschicht 12, 13 und die darüberliegende Deckschicht 14 bewirkt. Auch hier ist, wie oben erläutert, eine eventuelle Einschränkung im Randbereich des zweiten Gebietes gegeben.

Im Hinblick auf die Fototechnik kann es bei der beschriebenen Ausführungsform vorteilhaft sein, nach der Rückätzung des SOG und vor Aufbringen der Lackmaske eine dünne Silizium-Oxyd-Schicht von beispielsweise 100 nm aufzubringen. Auf diese Weise werden Probleme beim Belacken und Lackstripppen, wie sie bei Verwendung von SOG auftreten können, vermieden.

Die Lackmaske zur Freilegung der Metall 1-Oberfläche ist vorteilhafterweise deckungsgleich mit der strukturierten ersten oder zweiten Metallebene im ersten Gebiet, und zwar insbesondere mit der kapazitätsbestimmenden, d. h. "kleineren" Metallebene. Dabei kann die Lackmaske jeden Kondensator einzeln oder aber das gesamte Kondensatorfeld freilegen. Im ersten Fall ist für jeden Kondensator ein getrenntes Fenster vorgesehen, so daß bei jedem Kondensator ein durch die Justiertoleranz vorgegebener schmaler Randbereich des ersten (oder zweiten ) Gebietes existiert, in dem die Planarisierungsschicht Teil des Dielektrikums ist. Im zweiten Fall erstreckt sich das Fenster durchgehend über das gesamte erste Gebiet, so daß darauf zu achten ist, daß im Innern des ersten Gebietes keine Kurzschlüsse in der überliegenden Metall 2-Ebene entstehen (Gefahr von Metall-2-Resten nach der Metall-2-Ätzung).

Figur 5: Das Diagramm zeigt die über ein Kondensatorfeld (X/Y-Ebene) gemessene Dicke des Kondensatordielektrikums (Z-Achse). Figur 5a zeigt die Ergebnisse bei einem mit einem konventionellen Verfahren hergestellten Kondensatordielektrikum (mit SOG-Planarisierung), Figur 5b die Ergebnisse nach Durchführung des erfinderischen Verfahrens. In beiden Fällen beträgt das Intervall zwischen zwei Skalenteilen auf der Z-Achse 10 nm, so daß trotz des unterschiedlichen Sollwerts der Dielektrikumsdicke sofort erkennbar ist, daß mit dem erfinderischen Verfahren eine beträchtliche Verbesserung der Gleichmäßigkeit erreicht wird. Bei beiden Messungen wurde die Dielektrikumsdicke bei jedem zweiten Kondensator bestimmt, wobei die Ausdehnung eines Kondensators 40x40µm² betrug.

## Patentansprüche

1. Integrierte Halbleiterschaltung mit
- einem ersten Gebiet (1), in welchem Kondensatoren angeordnet sind, wobei die Kondensatorplatten aus einer ersten leitenden Schicht (11) und einer zweiten leitenden Schicht (15) gebildet sind,
- einem zweiten Gebiet (2), in welchem Schaltungselemente angeordnet sind,
und bei dem
- im ersten Gebiet (1) das Dielektrikum zwischen den Kondensatorplatten bis auf einen eventuellen Randbereich nur aus einer Deckschicht (14) besteht,
dadurch charakterisiert, daß
- im zweiten Gebiet (2) bis auf einen eventuellen Randbereich die erste und zweite leitende Schicht (11, 15) durch eine Planarisierungsschicht (12, 13) und die darüber angeordnete Deckschicht (14) gegeneinander isoliert sind.

2. Integrierte Halbleiterschaltung nach Anspruch 1, bei der die Deckschicht (14) aus Silizium-Oxyd besteht.

3. Integrierte Halbleiterschaltung nach einem der Ansprüche 1 bis 2, bei der die leitenden Schichten (11, 15) aus Polysilizium bestehen und die Planarisierungsschicht (12, 13) aus Silizium-Oxyd.

4. Integrierte Halbleiterschaltung nach einem der Ansprüche 1 bis 2, bei der die erste leitende Schicht (11) aus Polysilizium, die zweite leitende Schicht (15) aus Metall oder einer Metallegierung und die Planarisierungsschicht (12,13) aus einem dotierten Silikatglas besteht.

5. Integrierte Halbleiterschaltung nach einem der Ansprüche 1 bis 2, bei der die leitenden Schichten (11, 15) aus Metall oder einer Metallegierung bestehen und die Planarisierungsschicht (12, 13) aus Silizium-Oxyd und einer Hilfsschicht besteht.

6. Integrierte Halbleiterschaltung nach einem der Ansprüche 1 bis 5, bei der die Kapazität der Kondensatoren mittels der Dicke der Deckschicht (14) einstellbar ist.

7. A/D-Wandler nach einem der Ansprüche 1 bis 6.

8. Herstellverfahren für eine integrierte Halbleiterschaltung mit einem ersten Gebiet (1), in welchem Kondensatoren angeordnet sind, wobei die Kondensatorplatten aus einer ersten leitenden Schicht (11) und einer zweiten leitenden Schicht (15) gebildet sind, und mit einem zweiten Gebiet (2), in welchem Schaltungselemente angeordnet sind,
bei dem
- nach Herstellung der ersten leitenden Schicht (11) eine isolierende Planarisierungsschicht (12, 13) im ersten und zweiten Gebiet aufgebracht wird,
- die Planarisierungsschicht (12, 13) im ersten Gebiet (1) entfernt wird, bis die Oberfläche der ersten leitenden Schicht (11) bis auf einen eventuellen Randbereich freiliegt,
- ganzflächig im ersten und zweiten Gebiet eine isolierende Deckschicht (14) in einem Abscheideprozeß aufgebracht wird, und
- die zweite leitende Schicht (15) hergestellt wird.

9. Herstellverfahren nach Anspruch 8, bei dem die Planarisierungsschicht (12,13) mit Hilfe einer Fototechnik entfernt wird, wobei eine Fotomaske eingesetzt wird, die ein getrenntes Fenster für jeden Kondensator des ersten Gebietes aufweist.

10. Herstellverfahren nach Anspruch 8, bei dem die Planarisierungsschicht (12, 13) mit Hilfe einer Fototechnik entfernt wird, wobei eine Fotomaske eingesetzt wird, die ein zusammenhängendes Fenster für alle Kondensatoren des ersten Gebietes aufweist.

## Claims

1. Integrated semiconductor circuit having
- a first region (1) in which capacitors are arranged, the capacitor plates being made of a first conductive layer (11) and a second conductive layer (15),
- a second region (2) in which circuit elements are arranged,
and in which
- in the first region (1), the dielectric between the capacitor plates, as far as a possible edge region, consists only of a cover layer (14),
characterized in that
in the second region (2), as far as a possible edge region, the first and second conductive layers (11, 15) are insulated from one another by a planarizing layer (12, 13) and a cover layer (14) arranged thereon.

2. Integrated semiconductor circuit according to Claim 1, in which the cover layer (14) consists of silicon oxide.

3. Integrated semiconductor circuit according to one of Claims 1 and 2, in which the conductive layers (11, 15) consist of polysilicon, and the planarizing layer (12, 13) consists of silicon oxide.

4. Integrated semiconductor circuit according to one of Claims 1 and 2, in which the first conductive layer (11) consists of polysilicon, the second conductive layer (15) consists of metal or a metal alloy, and the planarizing layer (12, 13) consists of a doped silicate glass.

5. Integrated semiconductor circuit according to one of claims 1 and 2, in which the conductive layers (11, 15) consist of metal or a metal alloy, and the planarizing layer (12, 13) consists of silicon oxide and an auxiliary layer.

6. Integrated semiconductor circuit according to one of Claims 1 to 5, in which the capacitance of the capacitors can be adjusted by means of the thickness of the cover layer (14).

7. A/D converter according to one of Claims 1 to 6.

8. Process for producing an integrated semiconductor circuit having a first region (1), in which capacitors are arranged, the capacitor plates being made of a first conductive layer (11) and a second conductive layer (15), and having a second region (2), in which circuit elements are arranged,
in which
- after the first conductive layer (11) has been produced, an insulating planarizing layer (12, 13) is applied in the first and second regions,
- the planarizing layer (12, 13) in the first region (1) is removed until the surface of the first conductive layer (11) is exposed as far as a possible edge region,
- an insulating cover layer (14) is applied in a deposition process surface-wide in the first and second regions, and
- the second conductive layer (15) is produced.

9. Production process according to Claim 8, in which the planarizing layer (12, 13) is removed by a photographic technique, a photographic mask being used, which has a separate window for each capacitor of the first region.

10. Production process according to Claim 8, in which the planarizing layer (12, 13) is removed by a photographic technique, a photographic mask being used, which has a continuous window for all the capacitors in the first region.

## Revendications

1. Circuit intégré semi-conducteur avec
- une première zone (1) dans laquelle sont disposés des condensateurs, les plaques de condensateurs étant formées d'une première couche conductrice (11) et d'une deuxième couche conductrice (15),
- une deuxième zone (2) dans laquelle sont disposés des éléments de circuits, et pour lequel
- dans la première zone (1), le diélectrique entre les plaques de condensateurs se compose seulement d'une couche de recouvrement (14) sauf pour une éventuelle zone limite,
caractérisé en ce que
- dans la deuxième zone (2), sauf pour une éventuelle zone limite, la première et la deuxième couche conductrice (11, 15) sont isolées l'une de l'autre par une couche de planarisation (12, 13) et la couche de recouvrement (14) disposée au-dessus de celle-ci.

2. Circuit intégré semi-conducteur selon la revendication 1, pour lequel la couche de recouvrement (14) se compose d'oxyde de silicium.

3. Circuit intégré semi-conducteur selon l'une des revendications 1 à 2, pour lequel les couches conductrices (11, 15) se composent de polysilicium et la couche de planarisation (12, 13) d'oxyde de silicium.

4. Circuit intégré semi-conducteur selon l'une des revendications 1 à 2, pour lequel la première couche conductrice (11) se compose de polysilicium, la deuxième couche conductrice (15) de métal ou d'un alliage métallique et la couche de planarisation (12, 13) de verre silicate dopé.

5. Circuit intégré semi-conducteur selon l'une des revendications 1 à 2, pour lequel les couches conductrices (11, 15) se composent de métal ou d'un alliage métallique et la couche de planarisation (12, 13) d'oxyde de silicium et d'une couche auxiliaire.

6. Circuit intégré semi-conducteur selon l'une des revendications 1 à 5, pour lequel la capacité des condensateurs est ajustable au moyen de l'épaisseur de la couche de recouvrement (14).

7. Convertisseur A/N selon l'une des revendications 1 à 6.

8. Procédé de fabrication d'un circuit intégré semi-conducteur avec une première zone (1) dans laquelle sont disposés des condensateurs, les plaques de condensateurs étant formées d'une première couche conductrice (11) et d'une deuxième couche conductrice (15), et avec une deuxième zone (2) dans laquelle sont disposés des éléments de circuits,
pour lequel
- après la fabrication de la première couche conductrice (11), une couche de planarisation isolante (12, 13) est appliquée dans la première et la deuxième zone,
- dans la première zone (1), la couche de planarisation (12, 13) est éliminée jusqu'à ce que la surface de la première couche conductrice (11) soit mise à nue, sauf pour une éventuelle zone limite,
- dans la première et la deuxième zone, une couche de recouvrement isolante (14) est appliquée sur toute la surface par un procédé de dépôt et
- la deuxième couche conductrice (15) est fabriquée.

9. Procédé de fabrication selon la revendication 8, pour lequel la couche de planarisation (12, 13) est éliminée à l'aide d'une technique photographique, dans laquelle est utilisé un masque photographique qui présente une fenêtre séparée pour chaque condensateur de la première zone.

10. Procédé de fabrication selon la revendication 8, pour lequel la couche de planarisation (12, 13) est éliminée à l'aide d'une technique photographique, dans laquelle est utilisé un masque photographique qui présente une fenêtre continue pour tous les condensateurs de la première zone.
